# EUROPEAN PATENT APPLICATION

(11) **EP 4 632 406 A1**
(43) Date of publication of application: **15.10.2025**
(21) Application number: 23910401.1
(22) Date of filing: 22.12.2023
(51) Int. Cl.: G01R 31/388

(54) **BATTERY EVALUATION METHOD AND RELATED APPARATUS**

(30) Priority: 28.12.2022 CN 202211694236
(71) Applicant: Shenzhen Yinwang Intelligent Technologies Co., Ltd., Shenzhen, Guangdong 518110 (CN)
(72) Inventor: LV, Qing, Shenzhen, Guangdong 518129 (CN)
(74) Representative: Thun, Clemens
(86) International application number: PCT/CN2023/141067
(87) International publication number: WO 2024/140475

(57) **Abstract**

A battery evaluation method and a related apparatus are provided. The method includes: When a to-be-tested device meets a trigger condition for a battery evaluation task, a first device controls the to-be-tested device to perform a charging/discharging process corresponding to the battery evaluation task, and obtains test data of the to-be-tested device in the charging/discharging process (S201); the first device determines a battery evaluation result based on the test data (S202); and the first device sends the battery evaluation result to a second device (S203). According to the technical solution, efficiency of obtaining the battery evaluation result can be improved.

## Description

This application claims priority to Chinese Patent Application No. 202211694236.0, filed with the China National Intellectual Property Administration on December 28, 2022 and entitled "BATTERY EVALUATION METHOD AND RELATED APPARATUS", which is incorporated herein by reference in its entirety.

### TECHNICAL FIELD

This application relates to the field of new energy technologies, and in particular, to a battery evaluation method and a related apparatus.

### BACKGROUND

A state of health of a battery directly reflects an energy storage value of the battery. For an original equipment manufacturer, accurately obtaining the state of health of the vehicle battery can provide support for after-sales of the battery, and provide an effective input for research and development of the battery, thereby improving a product capability of an entire vehicle. For a user, accurately obtaining the state of health of the vehicle battery can enhance vehicle use confidence, alleviate mileage anxiety caused by external environment fluctuation, master a residual value of the vehicle, and make a value expectation of the entire vehicle more practical.

Currently, the vehicle is usually sent to a professional testing organization for testing, to obtain a battery evaluation result of the vehicle. However, in this solution, much manual participation and a long test period are required, and efficiency of obtaining the battery evaluation result needs to be improved.

### SUMMARY

Embodiments of this application provide a battery evaluation method and a related apparatus, to improve efficiency of obtaining a battery evaluation result.

According to a first aspect, an embodiment of this application provides a battery evaluation method. The method includes:

When a to-be-tested device meets a trigger condition for a battery evaluation task, a first device controls the to-be-tested device to perform a charging/discharging process corresponding to the battery evaluation task, and obtains test data of the to-be-tested device in the charging/discharging process;
the first device determines a battery evaluation result based on the test data; and
the first device sends the battery evaluation result to a second device.

According to the foregoing embodiment, when the to-be-tested device meets the trigger condition for the battery evaluation task, the first device controls the to-be-tested device to perform the charging/discharging process corresponding to the battery evaluation task, obtains the test data of the to-be-tested device in the charging/discharging process, and determines the battery evaluation result based on the test data. That is, the first device automatically performs the battery evaluation task to obtain the battery evaluation result of the to-be-tested device, and the first device sends the battery evaluation result to the second device. A user may learn of the battery evaluation result by viewing information received by the second device. In this way, the user does not need to send the to-be-tested device to a professional testing organization for battery evaluation. This reduces manual intervention and time costs, and improves efficiency of obtaining the battery evaluation result.

In a possible implementation, that the first device controls the to-be-tested device to perform the charging/discharging process corresponding to the battery evaluation task includes:

When obtaining authorization for performing the battery evaluation task, the first device controls the to-be-tested device to perform the charging/discharging process corresponding to the battery evaluation task.

In the foregoing implementation, that the first device performs the battery evaluation task when obtaining authorization for performing the battery evaluation task may be understood as that the first device performs the battery evaluation task when the user agrees to perform authorization. This can avoid affecting use of the to-be-tested device because the first device performs the battery evaluation task when the user does not agree to perform authorization.

In a possible implementation, the method further includes:

The first device sends request information to the second device when obtaining no authorization for performing the battery evaluation task; and
the first device receives authorization information sent by the second device, where the authorization information is used to authorize the first device to perform the battery evaluation task.

In the foregoing implementation, the first device sends the request information to the second device when obtaining no authorization for performing the battery evaluation task, to send, to the user, a request for obtaining authorization for performing the battery evaluation task. When the user agrees to perform authorization, the second device may send the authorization information to the first device, and the first device receives the authorization information sent by the second device, to obtain authorization for performing the battery evaluation task.

In a possible implementation, the authorization information includes a quantity of authorization times and/or an authorization period.

In the foregoing implementation, the authorization information may include the quantity of authorization times, or may include the authorization period, or may include both the quantity of authorization times and the authorization period. In this way, the user can flexibly set, based on an actual requirement, the quantity of times and/or the period for authorizing the first device to perform the battery evaluation task.

In a possible implementation, the trigger condition includes: A state of charge of the to-be-tested device can be accurately obtained.

In a possible implementation, the trigger condition includes: The to-be-tested device is in a fully-charged state.

In the foregoing implementation, when the to-be-tested device is in the fully-charged state, the first device is triggered to perform the battery evaluation task, so that stability and reliability of a trigger occasion can be ensured, and the first device can start to perform the battery evaluation task at a stable and reliable occasion.

In a possible implementation, the trigger condition includes: An accumulated mileage of the to-be-tested device is greater than a preset mileage, and/or an accumulated quantity of charging times of the to-be-tested device is greater than a preset quantity of times.

In the foregoing implementation, when the accumulated mileage of the to-be-tested device is greater than the preset mileage, and/or the accumulated quantity of charging times of the to-be-tested device is greater than the preset quantity of times, a battery of the to-be-tested device may be attenuated to an extent. In this case, it may be considered that it is necessary to evaluate a battery status of the to-be-tested device, and then the first device is triggered to perform the battery evaluation task. In this way, the first device can reduce unnecessary battery evaluation tasks, thereby saving computing resources.

In a possible implementation, that the first device controls the to-be-tested device to perform the charging/discharging process corresponding to the battery evaluation task, and obtains the test data of the to-be-tested device in the charging/discharging process includes:

The first device controls the to-be-tested device to perform discharging, and obtains a first state of charge after the to-be-tested device ends discharging; and
the first device obtains a second state of charge and an amount of charge of the to-be-tested device, where the second state of charge corresponds to a state of charge obtained when the to-be-tested device is charged until a charging end condition is met, and the amount of charge corresponds to an amount of charge of the to-be-tested device from ending discharging to being charged until the charging end condition is met, where
the test data includes the first state of charge, the second state of charge, and the amount of charge.

In the foregoing implementation, an available electricity quantity of the battery can be accurately reflected based on the first state of charge, the second state of charge, and the amount of charge, and the battery evaluation result with high precision is determined based on the available electricity quantity of the battery.

In a possible implementation, that the first device controls the to-be-tested device to perform discharging includes:

The first device controls the to-be-tested device to perform self-discharge until a discharging end condition is met; and/or
the first device sends first reminder information to the second device, where the first reminder information reminds the user to discharge the to-be-tested device until the discharging end condition is met.

In the foregoing implementation, the first device may control the to-be-tested device to perform self-discharge until the discharging end condition is met. In this way, the discharging process of the to-be-tested device is automatically implemented without manual intervention. Alternatively, the first device may send the first reminder information to the second device, to remind the user to discharge the to-be-tested device until the discharging end condition is met. In this way, the user can determine, based on an actual requirement, whether to discharge the to-be-tested device by using the to-be-tested device. This helps effectively utilize a battery level of the to-be-tested device.

In a possible implementation, the discharging end condition includes: The state of charge of the to-be-tested device is less than a first threshold.

In the foregoing implementation, when the state of charge of the to-be-tested device is less than the first threshold, the to-be-tested device ends discharging, so that the to-be-tested device can be in a low-battery state after ending discharging. In this case, the state of charge of the to-be-tested device is used as a state of charge obtained when the to-be-tested device starts to be charged. This helps ensure reliability of the state of charge obtained when the to-be-tested device starts to be charged.

In a possible implementation, the method further includes:

The first device monitors parameter data of the to-be-tested device in a process of controlling the to-be-tested device to perform self-discharge; and
when detecting that an exception occurs in the parameter data, the first device sends alarm information to the second device, and controls the to-be-tested device to terminate self-discharge.

In the foregoing implementation, in a process of controlling the to-be-tested device to perform self-discharge, when detecting that the exception occurs in the parameter data of the to-be-tested device, the first device sends the alarm information to the second device, so that the user can learn of the exception in a timely manner. In addition, the first device controls the to-be-tested device to terminate self-discharge, to help avoid a possible security risk in a timely manner.

In a possible implementation, the obtaining the first state of charge after the to-be-tested device ends discharging includes:

The first device obtains a first open-circuit voltage of the to-be-tested device after the to-be-tested device ends discharging and stays idle for a first period; and
the first device obtains the first state of charge based on a state of charge corresponding to the first open-circuit voltage.

In the foregoing implementation, the first open-circuit voltage after the to-be-tested device ends discharging and stays idle for a period of time is first obtained, and then the first state of charge is obtained based on the state of charge corresponding to the first open-circuit voltage. In this way, precision of the obtained first state of charge is high.

In a possible implementation, that the first device obtains the second state of charge and the amount of charge of the to-be-tested device includes:

After the to-be-tested device ends discharging and stays idle for the first period, the first device controls the to-be-tested device to be charged, and obtains the second state of charge and the amount of charge of the to-be-tested device.

In the foregoing implementation, after the to-be-tested device ends discharging and stays idle for the first period, the first device controls the to-be-tested device to start to be charged. Because the state of charge after the to-be-tested device ends discharging and stays idle for the first period may be accurately obtained based on the open-circuit voltage, the state of charge is used as the state of charge obtained when the to-be-tested device starts to be charged. This can improve reliability of the state of charge obtained when the to-be-tested device starts to be charged.

In a possible implementation, that the first device controls the to-be-tested device to be charged includes: When the to-be-tested device is connected to a charging pile, the first device turns on a charging switch of the to-be-tested device, to enable the to-be-tested device to be charged until the charging end condition is met.

In the foregoing implementation, when the to-be-tested device is connected to the charging pile, the first device may enable, by turning on the charging switch of the to-be-tested device, the to-be-tested device to be charged until the charging end condition is met. In this way, the charging process of the to-be-tested device is automatically implemented without manual intervention.

In a possible implementation, that the first device controls the to-be-tested device to be charged includes: The first device sends second reminder information to the second device when the to-be-tested device is connected to the charging pile, where the second reminder information reminds the user to turn on the charging switch of the to-be-tested device, to enable the to-be-tested device to be charged until the charging end condition is met.

In the foregoing implementation, when the to-be-tested device is connected to the charging pile, the first device may send the second reminder information to the second device, to remind the user to turn on the charging switch of the to-be-tested device. The user may turn on the charging switch of the to-be-tested device by using the second device, so that the to-be-tested device starts to be charged. In this way, a requirement that the user wants to control a charging start node can be met.

In a possible implementation, the charging end condition includes: The state of charge of the to-be-tested device can be accurately obtained.

In a possible implementation, the charging end condition includes: The to-be-tested device reaches the fully-charged state.

In the foregoing implementation, a state of charge obtained when the to-be-tested device reaches the fully-charged state is 100%, and the state of charge is reliable. In this case, the to-be-tested device ends charging. This can ensure reliability of a state of charge obtained when the to-be-tested device ends charging.

In a possible implementation, that the first device controls the to-be-tested device to be charged further includes:

When the to-be-tested device is not connected to the charging pile, the first device sends third reminder information to the second device, where the third reminder information reminds the user to connect the to-be-tested device to the charging pile.

In the foregoing implementation, when the to-be-tested device is not connected to the charging pile, the first device sends the third reminder information to the second device, to remind the user to connect the to-be-tested device to the charging pile. In this way, the charging switch of the to-be-tested device is turned on when the to-be-tested device is connected to the charging pile.

In a possible implementation, that the first device determines the battery evaluation result based on the test data includes:

The first device determines a maximum available electricity quantity of the to-be-tested device based on the amount of charge and a difference between the first state of charge and the second state of charge; and
the first device determines a battery state of health of the to-be-tested device based on a ratio of the maximum available electricity quantity of the to-be-tested device to a rated electricity quantity of the to-be-tested device, where
the battery evaluation result includes the battery state of health of the to-be-tested device.

In the foregoing implementation, the first device first evaluates the maximum available electricity quantity of the to-be-tested device based on the amount of charge and the difference between the first state of charge obtained when the to-be-tested device starts charging and the second state of charge obtained when the to-be-tested device ends charging, and then evaluates the battery state of health of the to-be-tested device based on the ratio of the maximum available electricity quantity of the to-be-tested device to the rated electricity quantity of the to-be-tested device. This manner of evaluating the battery state of health uses a "first" principle, that is, the battery state of health is evaluated by using a physical quantity directly related to the battery state of health and a logical relationship thereof, which is more interpretable. In this way, the evaluated battery state of health has high precision, and an evaluated value is close to a real value.

According to a second aspect, an embodiment of this application provides a battery evaluation method. The method includes:

A second device receives a battery evaluation result sent by a first device, where the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

According to the foregoing embodiment, when the to-be-tested device meets the trigger condition for the battery evaluation task, the first device controls the to-be-tested device to perform the charging/discharging process corresponding to the battery evaluation task, obtains the test data of the to-be-tested device in the charging/discharging process, and determines the battery evaluation result based on the test data. That is, the first device automatically performs the battery evaluation task to obtain the battery evaluation result of the to-be-tested device, the first device sends the battery evaluation result to the second device, and the second device receives the battery evaluation result sent by the first device. A user may learn of the battery evaluation result by viewing information received by the second device. In this way, the user does not need to send the to-be-tested device to a professional testing organization for battery evaluation. This reduces manual intervention and time costs, and improves efficiency of obtaining the battery evaluation result.

In a possible implementation, the method further includes:

The second device receives request information sent by the first device when the first device obtains no authorization for performing the battery evaluation task; and
the second device sends authorization information to the first device, where the authorization information is used to authorize the first device to perform the battery evaluation task.

In the foregoing implementation, the second device receives the request information sent by the first device when the first device obtains no authorization for performing the battery evaluation task, where the request information is used to send, to the user, a request for obtaining authorization for performing the battery evaluation task. When the user agrees to perform authorization, the second device may send the authorization information to the first device, so that the first device obtains authorization for performing the battery evaluation task.

In a possible implementation, the authorization information includes a quantity of authorization times and/or an authorization period.

In the foregoing implementation, the authorization information may include the quantity of authorization times, or may include the authorization period, or may include both the quantity of authorization times and the authorization period. In this way, the user can flexibly set, based on an actual requirement, the quantity of times and/or the period for authorizing the first device to perform the battery evaluation task.

In a possible implementation, the trigger condition includes: A state of charge of the to-be-tested device can be accurately obtained.

In a possible implementation, the trigger condition includes: The to-be-tested device is in a fully-charged state.

In the foregoing implementation, when the to-be-tested device is in the fully-charged state, the first device is triggered to perform the battery evaluation task, so that stability and reliability of a trigger occasion can be ensured, and the first device can start to perform the battery evaluation task at a stable and reliable occasion.

In a possible implementation, the trigger condition includes: An accumulated mileage of the to-be-tested device is greater than a preset mileage, and/or an accumulated quantity of charging times of the to-be-tested device is greater than a preset quantity of times.

In the foregoing implementation, when the accumulated mileage of the to-be-tested device is greater than the preset mileage, and/or the accumulated quantity of charging times of the to-be-tested device is greater than the preset quantity of times, a battery of the to-be-tested device may be attenuated to an extent. In this case, it may be considered that it is necessary to evaluate a battery status of the to-be-tested device, and then the first device is triggered to perform the battery evaluation task. In this way, the first device can reduce unnecessary battery evaluation tasks, thereby saving computing resources.

In a possible implementation, the method further includes:

The second device receives first reminder information sent by the first device when the first device controls the to-be-tested device to perform discharging, where the first reminder information reminds a user to discharge the to-be-tested device until a discharging end condition is met.

In the foregoing implementation, the second device receives the first reminder information sent by the first device, where the first reminder information reminds the user to discharge the to-be-tested device until the discharging end condition is met. In this way, the user can determine, based on an actual requirement, whether to discharge the to-be-tested device by using the to-be-tested device. This helps effectively utilize a battery level of the to-be-tested device.

In a possible implementation, the discharging end condition includes: The state of charge of the to-be-tested device is less than a first threshold.

In the foregoing implementation, when the state of charge of the to-be-tested device is less than the first threshold, the to-be-tested device ends discharging, so that the to-be-tested device can be in a low-battery state after ending discharging. In this case, the state of charge of the to-be-tested device is used as a state of charge obtained when the to-be-tested device starts to be charged. This helps ensure reliability of the state of charge obtained when the to-be-tested device starts to be charged.

In a possible implementation, the method further includes:

The second device receives alarm information sent by the first device when the first device detects, in a process of controlling the to-be-tested device to perform self-discharge, that an exception occurs in parameter data of the to-be-tested device.

In the foregoing implementation, the second device receives the alarm information sent by the first device, where the alarm information indicates that the exception occurs in the parameter data of the to-be-tested device in a self-discharge process, so that the user can learn of the exception in a timely manner, to help avoid a possible security risk.

In a possible implementation, the method further includes:

The second device receives second reminder information sent by the first device when the first device controls the to-be-tested device to be charged and the to-be-tested device is connected to a charging pile, where the second reminder information reminds the user to turn on a charging switch of the to-be-tested device, to enable the to-be-tested device to be charged until a charging end condition is met; and
the second device turns on the charging switch of the to-be-tested device, to enable the to-be-tested device to be charged until the charging end condition is met.

In the foregoing implementation, the second device receives the second reminder information sent by the first device, where the second reminder information reminds the user to turn on the charging switch of the to-be-tested device. The user may turn on the charging switch of the to-be-tested device by using the second device, so that the to-be-tested device starts to be charged. In this way, a requirement that the user wants to control a charging start node can be met.

In a possible implementation, the charging end condition includes: A state of charge of the to-be-tested device can be accurately obtained.

In a possible implementation, the charging end condition includes: The to-be-tested device reaches the fully-charged state.

In the foregoing implementation, the to-be-tested device ends charging when reaching the fully-charged state, so that the state of charge obtained when the to-be-tested device ends charging is 100%, and the state of charge is reliable. This helps ensure reliability of the state of charge obtained when the to-be-tested device ends charging.

In a possible implementation, the method further includes:

The second device receives third reminder information sent by the first device when the first device controls the to-be-tested device to be charged and the to-be-tested device is not connected to the charging pile, where the third reminder information reminds the user to connect the to-be-tested device to the charging pile.

In the foregoing implementation, the second device receives the third reminder information sent by the first device, where the third reminder information reminds the user to connect the to-be-tested device to the charging pile. In this way, the charging switch of the to-be-tested device is turned on when the to-be-tested device is connected to the charging pile.

In a possible implementation, the test data includes a first state of charge, a second state of charge, and an amount of charge. The first state of charge corresponds to a state of charge obtained after the to-be-tested device ends discharging, the second state of charge corresponds to a state of charge obtained when the to-be-tested device is charged until the charging end condition is met, and the amount of charge corresponds to an amount of charge of the to-be-tested device from ending discharging to being charged until the charging end condition is met.

In the foregoing implementation, an available electricity quantity of the battery can be accurately reflected based on the first state of charge, the second state of charge, and the amount of charge, and the battery evaluation result with high precision is determined based on the available electricity quantity of the battery.

In a possible implementation, the battery evaluation result includes a battery state of health of the to-be-tested device, and the battery state of health of the to-be-tested device is determined based on a ratio of a maximum available electricity quantity of the to-be-tested device to a rated electricity quantity of the to-be-tested device. The maximum available electricity quantity of the to-be-tested device is determined based on the amount of charge and a difference between the first state of charge and the second state of charge.

In the foregoing implementation, the maximum available electricity quantity of the to-be-tested device is first evaluated based on the amount of charge and the difference between the first state of charge obtained when the to-be-tested device starts charging and the second state of charge obtained when the to-be-tested device ends charging, and then the battery state of health of the to-be-tested device is evaluated based on the ratio of the maximum available electricity quantity of the to-be-tested device to the rated electricity quantity of the to-be-tested device. This manner of evaluating the battery state of health uses a "first" principle, that is, the battery state of health is evaluated by using a physical quantity directly related to the battery state of health and a logical relationship thereof, which is more interpretable. In this way, the evaluated battery state of health has high precision, and an evaluated value is close to a real value.

According to a third aspect, an embodiment of this application provides a battery evaluation apparatus. The apparatus includes a module or unit configured to perform the method according to any one of the first aspect or the possible implementations of the first aspect.

In a possible implementation, the apparatus includes:
a processing unit, configured to: when a to-be-tested device meets a trigger condition for a battery evaluation task, control the to-be-tested device to perform a charging/discharging process corresponding to the battery evaluation task, obtain test data of the to-be-tested device in the charging/discharging process, and determine a battery evaluation result based on the test data; and
a transceiver unit, configured to send the battery evaluation result to a second device.

In a possible implementation, when controlling the to-be-tested device to perform the charging/discharging process corresponding to the battery evaluation task, the processing unit is specifically configured to: when obtaining authorization for performing the battery evaluation task, control the to-be-tested device to perform the charging/discharging process corresponding to the battery evaluation task.

In a possible implementation, the transceiver unit is further configured to:
send request information to the second device when obtaining no authorization for performing the battery evaluation task; and
receive authorization information sent by the second device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, when controlling the to-be-tested device to perform the charging/discharging process corresponding to the battery evaluation task, and obtaining the test data of the to-be-tested device in the charging/discharging process, the processing unit is specifically configured to:
control the to-be-tested device to perform discharging, and obtain a first state of charge after the to-be-tested device ends discharging; and
obtain a second state of charge and an amount of charge of the to-be-tested device, where the second state of charge corresponds to a state of charge obtained when the to-be-tested device is charged until a charging end condition is met, and the amount of charge corresponds to an amount of charge of the to-be-tested device from ending discharging to being charged until the charging end condition is met, where
the test data includes the first state of charge, the second state of charge, and the amount of charge.

In a possible implementation, when controlling the to-be-tested device to perform discharging, the processing unit is specifically configured to control the to-be-tested device to perform self-discharge until a discharging end condition is met.

In a possible implementation, the transceiver unit is further configured to send first reminder information to the second device, where the first reminder information reminds a user to discharge the to-be-tested device until the discharging end condition is met.

In a possible implementation, the discharging end condition includes: The state of charge of the to-be-tested device is less than a first threshold.

In a possible implementation, the processing unit is further configured to: monitor parameter data of the to-be-tested device in a process of controlling the to-be-tested device to perform self-discharge, and control, when detecting that an exception occurs in the parameter data, the to-be-tested device to terminate self-discharge.

The transceiver unit is further configured to send alarm information to the second device when detecting that the exception occurs in the parameter data.

In a possible implementation, when obtaining the first state of charge after the to-be-tested device ends discharging, the processing unit is specifically configured to:
obtain a first open-circuit voltage of the to-be-tested device after the to-be-tested device ends discharging and stays idle for a first period; and
obtain the first state of charge based on a state of charge corresponding to the first open-circuit voltage.

In a possible implementation, when obtaining the second state of charge and the amount of charge of the to-be-tested device, the processing unit is specifically configured to: after the to-be-tested device ends discharging and stays idle for the first period, control the to-be-tested device to be charged, and obtain the second state of charge and the amount of charge of the to-be-tested device.

In a possible implementation, when controlling the to-be-tested device to be charged, the processing unit is specifically configured to: when the to-be-tested device is connected to a charging pile, turn on a charging switch of the to-be-tested device, to enable the to-be-tested device to be charged until the charging end condition is met.

In a possible implementation, the transceiver unit is further configured to send second reminder information to the second device when the to-be-tested device is connected to the charging pile, where the second reminder information reminds the user to turn on the charging switch of the to-be-tested device, to enable the to-be-tested device to be charged until the charging end condition is met.

In a possible implementation, the charging end condition includes: A state of charge of the to-be-tested device can be accurately obtained.

In a possible implementation, the charging end condition includes: The to-be-tested device reaches the fully-charged state.

In a possible implementation, the transceiver unit is further configured to send third reminder information to the second device when the to-be-tested device is not connected to the charging pile, where the third reminder information reminds the user to connect the to-be-tested device to the charging pile.

In a possible implementation, when determining the battery evaluation result based on the test data, the processing unit is specifically configured to:
determine a maximum available electricity quantity of the to-be-tested device based on the amount of charge and a difference between the first state of charge and the second state of charge; and
determine a battery state of health of the to-be-tested device based on a ratio of the maximum available electricity quantity of the to-be-tested device to a rated electricity quantity of the to-be-tested device, where
the battery evaluation result includes the battery state of health of the to-be-tested device.

For technical effects brought by the third aspect and any possible implementation, refer to descriptions of technical effects corresponding to the first aspect and a corresponding implementation.

According to a fourth aspect, an embodiment of this application provides a battery evaluation apparatus. The apparatus includes a module or unit configured to perform the method according to any one of the second aspect or the possible implementations of the second aspect.

In a possible implementation, the apparatus includes:
a transceiver unit, configured to receive a battery evaluation result sent by a first device, where the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

In a possible implementation, the transceiver unit is further configured to:
receive request information sent by the first device when the first device obtains no authorization for performing the battery evaluation task; and
send authorization information to the first device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, the transceiver unit is further configured to receive first reminder information sent by the first device when the first device controls the to-be-tested device to perform discharging, where the first reminder information reminds a user to discharge the to-be-tested device until a discharging end condition is met.

In a possible implementation, the discharging end condition includes: The state of charge of the to-be-tested device is less than a first threshold.

In a possible implementation, the transceiver unit is further configured to receive alarm information sent by the first device when the first device detects, in a process of controlling the to-be-tested device to perform self-discharge, that an exception occurs in parameter data of the to-be-tested device.

In a possible implementation, the transceiver unit is further configured to receive second reminder information sent by the first device when the first device controls the to-be-tested device to be charged and the to-be-tested device is connected to a charging pile, where the second reminder information reminds the user to turn on a charging switch of the to-be-tested device, to enable the to-be-tested device to be charged until a charging end condition is met. The apparatus further includes:
a processing unit, configured to turn on the charging switch of the to-be-tested device, to enable the to-be-tested device to be charged until the charging end condition is met.

In a possible implementation, the charging end condition includes: The state of charge of the to-be-tested device can be accurately obtained.

In a possible implementation, the charging end condition includes: The to-be-tested device reaches the fully-charged state.

In a possible implementation, the transceiver unit is further configured to: receive third reminder information sent by the first device when the first device controls the to-be-tested device to be charged and the to-be-tested device is not connected to the charging pile, where the third reminder information reminds the user to connect the to-be-tested device to the charging pile.

In a possible implementation, the test data includes a first state of charge, a second state of charge, and an amount of charge. The first state of charge corresponds to a state of charge obtained after the to-be-tested device ends discharging, the second state of charge corresponds to a state of charge obtained when the to-be-tested device is charged until the charging end condition is met, and the amount of charge corresponds to an amount of charge of the to-be-tested device from ending discharging to being charged until the charging end condition is met.

In a possible implementation, the battery evaluation result includes a battery state of health of the to-be-tested device, and the battery state of health of the to-be-tested device is determined based on a ratio of a maximum available electricity quantity of the to-be-tested device to a rated electricity quantity of the to-be-tested device. The maximum available electricity quantity of the to-be-tested device is determined based on the amount of charge and a difference between the first state of charge and the second state of charge.

For technical effects brought by the fourth aspect and any possible implementation, refer to descriptions of technical effects corresponding to the second aspect and a corresponding implementation.

According to a fifth aspect, an embodiment of this application provides an electronic device. The electronic device includes a processor. The processor is coupled to a memory, and may be configured to execute a computer program or instructions in the memory, to implement the method according to either of the first aspect and the second aspect or any one of the possible implementations of the first aspect and the second aspect. Optionally, the electronic device further includes the memory. Optionally, the electronic device further includes a communication interface, and the processor is coupled to the communication interface.

According to a sixth aspect, an embodiment of this application provides a computer-readable storage medium. The computer-readable storage medium stores a computer program or instructions. When the computer program or the instructions are executed, the method according to either of the first aspect and the second aspect or any one of the possible implementations of the first aspect and the second aspect is implemented.

According to a seventh aspect, an embodiment of this application provides a computer program product. The computer program product includes a computer program or instructions. When the computer program or the instructions are executed, the method according to either of the first aspect and the second aspect or any one of the possible implementations of the first aspect and the second aspect is implemented.

According to an eighth aspect, an embodiment of this application provides a chip. The chip includes a processor. The processor is configured to execute a computer program or instructions. When the processor executes the computer program or the instructions, the chip is enabled to perform the method according to either of the first aspect and the second aspect or any one of the possible implementations of the first aspect and the second aspect. Optionally, the chip further includes a communication interface, and the communication interface is configured to receive a signal or send a signal.

According to a ninth aspect, an embodiment of this application provides a system. The system includes the apparatus according to any one of the third aspect or the possible implementations of the third aspect and the apparatus according to any one of the fourth aspect or the possible implementations of the fourth aspect.

According to a tenth aspect, an embodiment of this application provides a system. The system includes a first device and a second device. The first device is configured to perform the method according to any one of the first aspect or the possible implementations of the first aspect, and the second device is configured to perform the method according to any one of the second aspect or the possible implementations of the second aspect.

In addition, in a process of performing the method according to either of the first aspect and the second aspect and any one of the possible implementations of the first aspect and the second aspect, a process related to sending information and/or receiving information and the like in the method may be understood as a process of outputting information by a processor and/or a process of receiving input information by the processor. When outputting the information, the processor may output the information to a transceiver (or a communication interface or a sending module), so that the transceiver transmits the information. After the information is output by the processor, other processing may further need to be performed on the information before the information arrives at the transceiver. Similarly, when the processor receives the input information, the transceiver (or the communication interface or the sending module) receives the information, and inputs the information into the processor. Further, after the transceiver receives the information, other processing may need to be performed on the information before the information is input into the processor.

Based on the foregoing principle, for example, sending information in the foregoing method may be understood as outputting information by the processor. For another example, receiving information may be understood as receiving input information by the processor.

Optionally, operations such as transmission, sending, and receiving related to the processor may be more generally understood as operations such as an output, receiving, and an input of the processor, unless otherwise specified, or provided that the operations do not contradict actual functions or internal logic of the operations in related descriptions.

Optionally, in a process of performing the method according to either of the first aspect and the second aspect and any one of the possible implementations of the first aspect and the second aspect, the processor may be a processor specially configured to perform the method, or may be a processor, for example, a general-purpose processor, that performs the method by executing computer instructions in a memory. The memory may be a non-transitory (non-transitory) memory, for example, a read-only memory (read-only memory, ROM). The memory and the processor may be integrated on a same chip, or may be separately disposed on different chips. A type of the memory and a manner of disposing the memory and the processor are not limited in embodiments of this application.

### BRIEF DESCRIPTION OF DRAWINGS

To describe the technical solutions in embodiments of this application more clearly, the following briefly describes the accompanying drawings used in embodiments of this application. It is clear that, the accompanying drawings described below show merely some embodiments of this application, and a person of ordinary skill in the art may still derive other drawings from these accompanying drawings without creative efforts.
FIG. 1 is a diagram of an application scenario of a battery evaluation method according to an embodiment of this application;
FIG. 2 is a schematic flowchart of a battery evaluation method according to an embodiment of this application;
FIG. 3 is a diagram of a structure of a battery evaluation apparatus according to an embodiment of this application;
FIG. 4 is a diagram of a structure of an electronic device according to an embodiment of this application; and
FIG. 5 is a diagram of a structure of a chip according to an embodiment of this application.

### DESCRIPTION OF EMBODIMENTS

To make objectives, technical solutions, and advantages of this application clearer, the following describes embodiments of this application with reference to accompanying drawings in embodiments of this application.

In this application, the word such as "example" or "for example" represents giving an example, an illustration, or a description. Any embodiment or design scheme described as an "example" or "for example" in this application should not be explained as being more preferred or having more advantages than another embodiment or design schemes. To be precise, the word such as "example" or "for example" is intended to present a related concept in a specific manner.

"First", "second", "third", and the like in embodiments of this application are intended to distinguish between different objects but do not indicate a particular order. In addition, terms such as "include" and "have" and any other variants thereof are intended to cover a non-exclusive inclusion. For example, processes, methods, systems, products, devices that include a series of steps or units are not limited to listed steps or units, but optionally further include steps units that are not listed, or optionally further include other steps or units inherent to these processes, methods, products, devices.

The phrase "embodiment" in this specification means that a specific feature, structure, or characteristic described with reference to the embodiment may be included in at least one embodiment of this application. The phrase shown in various locations in the specification may neither necessarily mean a same embodiment, nor mean an independent or optional embodiment exclusive from another embodiment. It can be explicitly and implicitly understood by a person skilled in the art that, in embodiments of this application, unless otherwise stated or there is a logic conflict, terms and/or descriptions in all embodiments are consistent and may be mutually referenced, and technical features in different embodiments may be combined into a new embodiment based on an internal logical relationship thereof.

It should be understood that, in this application, "at least one (item)" means one or more, "a plurality of" means two or more, "at least two (items)" means two, three, or more, and "and/or" is used to describe an association relationship between associated objects, and indicates that there may be three relationships. For example, "A and/or B" may indicate the following three cases: Only A exists, only B exists, and both A and B exist, where A and B may be singular or plural. The character "/" usually indicates an "or" relationship between the associated objects. "At least one of the following items (pieces)" or a similar expression thereof indicates any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

A method provided in this application may be applied to various communication systems, such as an internet of things (internet of things, IoT) system, a narrowband internet of things (narrowband internet of things, NB-IoT) system, a long term evolution (long term evolution, LTE) system, a 5th generation (5th generation, 5G) communication system, and a new communication system (for example, 6G) emerging in future communication development.

Technical solutions provided in this application may be further applied to machine type communication (machine type communication, MTC), a long term evolution-machine (long term evolution-machine, LTE-M) technology, a device-to-device (device-to-device, D2D) network, a machine-to-machine (machine-to-machine, M2M) network, an internet of things (internet of things, IoT) network, or another network. The IoT network may include, for example, an internet of vehicles. Communication modes in an internet of vehicles system are collectively referred to as vehicle-to-everything (vehicle-to-everything, V2X, where X may represent everything). For example, the V2X may include vehicle-to-vehicle (vehicle-to-vehicle, V2V) communication, vehicle-to-infrastructure (vehicle-to-infrastructure, V2I) communication, vehicle-to-pedestrian (vehicle-to-pedestrian, V2P) communication, vehicle-to-network (vehicle-to-network, V2N) communication, or the like.

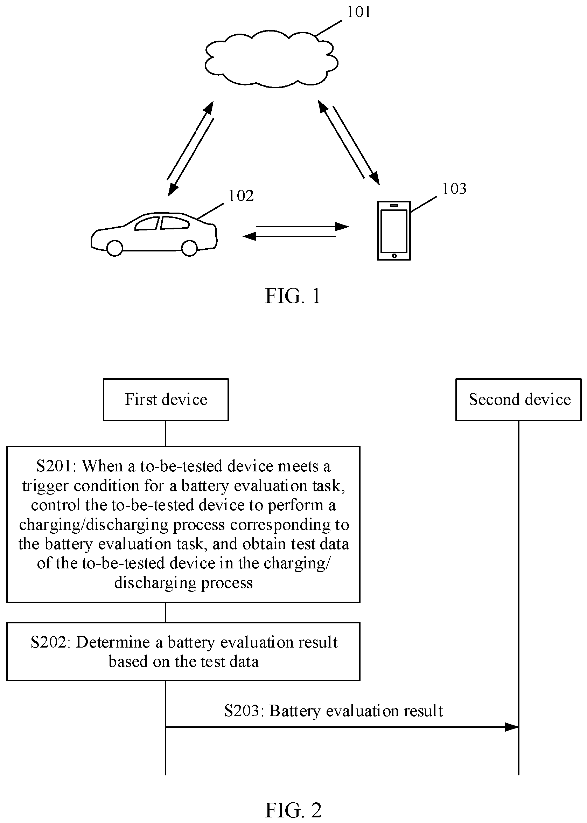

FIG. 1 is a diagram of an application scenario of a battery evaluation method according to an embodiment of this application. The application scenario includes a cloud 101, a vehicle 102, and user equipment 103. The cloud 101 may communicate with the vehicle 102 to provide a plurality of services for the vehicle 102. The cloud 101 may also communicate with the user equipment 103, and the vehicle 102 may also communicate with the user equipment 103. The cloud 101 may include a cloud server and/or a cloud virtual machine. The vehicle 102 may be an electric vehicle with a power battery, for example, an electric vehicle, an electric train, or an electric bicycle. The user equipment 103 may be a device that can provide a communication service for a user, for example, a cellular phone, a smartphone, a personal digital assistant (personal digital assistant, PDA) computer, a tablet computer, a handheld device, or a wearable device.

In a possible implementation, when the vehicle 102 meets a trigger condition for a battery evaluation task, the cloud 101 automatically performs the battery evaluation task to evaluate a battery status of the vehicle 102, to obtain a battery evaluation result of the vehicle 102. The cloud 101 sends the battery evaluation result of the vehicle 102 to the user equipment 103. For specific related descriptions, refer to the following embodiments.

In another possible implementation, the cloud 101 delivers a battery evaluation program to the vehicle 102. When the vehicle 102 meets a trigger condition for a battery evaluation task, the vehicle 102 automatically performs the battery evaluation task to evaluate a battery status of the vehicle 102, to obtain a battery evaluation result of the vehicle 102. The vehicle 102 sends the battery evaluation result of the vehicle 102 to the user equipment 103. For specific related descriptions, refer to the following embodiments.

FIG. 2 is a schematic flowchart of a battery evaluation method according to an embodiment of this application. The battery evaluation method may be applied to the scenario shown in FIG. 1. The battery evaluation method may include but is not limited to the following step S201 to step S203.

S201: When a to-be-tested device meets a trigger condition for a battery evaluation task, a first device controls the to-be-tested device to perform a charging/discharging process corresponding to the battery evaluation task, and obtains test data of the to-be-tested device in the charging/discharging process.

The to-be-tested device in this embodiment of this application is a device with a power battery, and may be an electric vehicle, for example, the vehicle 102 in FIG. 1, or another driving device having a function of the vehicle 102. This embodiment of this application is intended to evaluate a battery status of the to-be-tested device.

The first device in this embodiment of this application is a device equipped with a processor that can be configured to execute computer instructions, and is configured to perform the battery evaluation method in this embodiment of this application. In an example, the first device may be a server device, for example, may be the cloud 101 in FIG. 1, or another component like a server or a virtual machine that has a function of the cloud 101, or a device integrated with the cloud 101. In another example, the first device may be a vehicle-end device, for example, may be the vehicle 102 in FIG. 1, or a control component in the vehicle 102, or another driving device having a function of the vehicle 102.

The trigger condition for the battery evaluation task is a condition for triggering the first device to evaluate the battery status of the to-be-tested device. The battery status may include but is not limited to a battery state of health (state of health, SOH) and/or a battery state of energy (state of energy, SOE). The charging/discharging process corresponding to the battery evaluation task is an operation that needs to be performed by the to-be-tested device to support the battery evaluation task. The charging/discharging process may include at least one discharging process and at least one charging process. The test data of the to-be-tested device in the charging/discharging process may be understood as data related to the battery status, and is used to evaluate the battery status.

Optionally, the first device may detect, in real time or periodically, whether the to-be-tested device meets the trigger condition for the battery evaluation task. When detecting that the to-be-tested device meets the trigger condition for the battery evaluation task, the first device performs the battery evaluation task to evaluate the battery status of the to-be-tested device.

S202: The first device determines a battery evaluation result based on the test data.

The first device may evaluate the battery status of the to-be-tested device based on the test data and a relationship between the test data and the battery status, to obtain the battery evaluation result of the to-be-tested device. The battery evaluation result may include but is not limited to a battery state of health and/or a battery state of energy.

S203: The first device sends the battery evaluation result to a second device.

The second device in this embodiment of this application is a device that can provide a communication service, and is configured to exchange information with the first device. In an example, the second device may be user equipment, for example, may be the user equipment 103 in FIG. 1, or another device having a function of the user equipment 103. In another example, the second device may be a vehicle-mounted device, for example, may be a head unit screen in the vehicle 102 shown in FIG. 1.

The first device sends the battery evaluation result to the second device. Correspondingly, the second device receives the battery evaluation result sent by the first device.

According to the foregoing embodiment, when the to-be-tested device meets the trigger condition for the battery evaluation task, the first device controls the to-be-tested device to perform the charging/discharging process corresponding to the battery evaluation task, obtains the test data of the to-be-tested device in the charging/discharging process, and determines the battery evaluation result based on the test data. That is, the first device automatically performs the battery evaluation task to obtain the battery evaluation result of the to-be-tested device, and the first device sends the battery evaluation result to the second device. A user may learn of the battery evaluation result by viewing information received by the second device. In this way, the user does not need to send the to-be-tested device to a professional testing organization for battery evaluation. This reduces manual intervention and time costs, and improves efficiency of obtaining the battery evaluation result.

It should be noted that the to-be-tested device is available in a process of performing battery evaluation in this embodiment of this application, so that a temporary use requirement of the user for the to-be-tested device during battery evaluation can be met. For example, when the to-be-tested device is performing the charging/discharging process corresponding to the battery evaluation task, if the user wants to use the to-be-tested device, the user may actively interrupt the charging/discharging process of the to-be-tested device, and then use the to-be-tested device.

In a possible embodiment, that the first device controls the to-be-tested device to perform the charging/discharging process corresponding to the battery evaluation task may be specifically: When obtaining authorization for performing the battery evaluation task, the first device controls the to-be-tested device to perform the charging/discharging process corresponding to the battery evaluation task.

In addition to that the to-be-tested device meets the trigger condition for the battery evaluation task, the first device further needs to obtain authorization for performing the battery evaluation task. In this case, the first device performs the battery evaluation task.

Optionally, after detecting that the to-be-tested device meets the trigger condition for the battery evaluation task, the first device further detects whether the first device obtains authorization for performing the battery evaluation task. When the first device obtains authorization for performing the battery evaluation task, the first device performs the battery evaluation task to evaluate the battery status of the to-be-tested device.

According to this embodiment of this application, that the first device performs the battery evaluation task when obtaining authorization for performing the battery evaluation task may be understood as that the first device performs the battery evaluation task when the user agrees to perform authorization. This can avoid affecting use of the to-be-tested device because the first device performs the battery evaluation task when the user does not agree to perform authorization.

In a possible embodiment, the first device sends request information to the second device when obtaining no authorization for performing the battery evaluation task; and the first device receives authorization information sent by the second device, where the authorization information is used to authorize the first device to perform the battery evaluation task.

The first device sends the request information to the second device when obtaining no authorization for performing the battery evaluation task. The request information is used to send, to the user, a request for obtaining authorization for performing the battery evaluation task. Correspondingly, the second device receives the request information sent by the first device, and returns, to the first device, information in response to the request information.

Optionally, if the user agrees to perform authorization, the second device may send the authorization information to the first device. The authorization information is used to authorize the first device to perform the battery evaluation task. Correspondingly, the first device receives the authorization information sent by the second device. When the first device receives the authorization information sent by the second device, it indicates that the first device obtains authorization for performing the battery evaluation task.

Optionally, if the user does not agree to perform authorization, the second device may send authorization rejection information to the first device. The authorization rejection information is used to reject to authorize the first device to perform the battery evaluation task. Correspondingly, the first device receives the authorization information sent by the second device. When the first device receives the authorization rejection information sent by the second device, it indicates that the first device obtains no authorization for performing the battery evaluation task.

According to this embodiment of this application, the first device sends the request information to the second device when obtaining no authorization for performing the battery evaluation task, to send, to the user, the request for obtaining authorization for performing the battery evaluation task. When the user agrees to perform authorization, the second device may send the authorization information to the first device, and the first device receives the authorization information sent by the second device, to obtain authorization for performing the battery evaluation task.

In a possible embodiment, the authorization information includes a quantity of authorization times and/or an authorization period.

In an example, the authorization information may include a quantity of authorization times, and the quantity of authorization times is a quantity of times for authorizing the first device to perform the battery evaluation task. The quantity of authorization times may be a quantity of times that is set by default, or may be a quantity of times customized by the user. This is not limited in embodiments of this application. If a quantity of times that the first device performs the battery evaluation task does not reach the quantity of authorization times, when the battery evaluation task is triggered, the first device does not need to send the request information to the second device, and can directly perform the battery evaluation task. If a quantity of times that the first device performs the battery evaluation task reaches the quantity of authorization times, when the battery evaluation task is triggered, the first device needs to resend the request information to the second device, and can perform the battery evaluation task only when re-obtaining authorization.

For example, the quantity of authorization times may be one. In this case, the first device is authorized only once (that is, a current time) to perform the battery evaluation task. When the battery evaluation task is triggered next time, the first device needs to send the request information to the second device again, and can perform the battery evaluation task only when obtaining authorization again. For another example, the quantity of authorization times may be more than one, for example, two. In this case, the first device is authorized twice (that is, including a current time and a next time) to perform the battery evaluation task. When the battery evaluation task is triggered next time, the first device does not need to send the request information to the second device again. In this case, the first device has been authorized to directly perform the battery evaluation task.

In another example, the authorization information may include an authorization period, and the authorization period is a period for authorizing the first device to perform the battery evaluation task. The authorization period may be a period that is set by default, or may be a period customized by the user. This is not limited in embodiments of this application. If a current period does not exceed the authorization period, when the battery evaluation task is triggered, the first device does not need to send the request information to the second device, and can directly perform the battery evaluation task. If a current period exceeds the authorization period, when the battery evaluation task is triggered, the first device needs to resend the request information to the second device, and can perform the battery evaluation task only when re-obtaining authorization.

For example, the authorization period may be one month. In this case, the first device is authorized to perform the battery evaluation task in one month. In the month, when the battery evaluation task is triggered, the first device does not need to send the request information to the second device. In this case, the first device has been authorized to directly perform the battery evaluation task. After the month, when the battery evaluation task is triggered, the first device needs to resend the request information to the second device, and can perform the battery evaluation task only when re-obtaining authorization.

In still another example, the authorization information may include both a quantity of authorization times and an authorization period. Optionally, if a quantity of times that the first device performs the battery evaluation task does not reach the quantity of authorization times and a current period does not exceed the authorization period, when the battery evaluation task is triggered, the first device does not need to send the request information to the second device, and can directly perform the battery evaluation task. If a quantity of times that the first device performs the battery evaluation task reaches the quantity of authorization times or a current period exceeds the authorization period, when the battery evaluation task is triggered, the first device needs to resend the request information to the second device, and can perform the battery evaluation task only when re-obtaining authorization.

According to this embodiment of this application, the authorization information may include the quantity of authorization times, or may include the authorization period, or may include both the quantity of authorization times and the authorization period. In this way, the user can flexibly set, based on an actual requirement, the quantity of times and/or the period for authorizing the first device to perform the battery evaluation task.

In a possible embodiment, the trigger condition includes: A state of charge of the to-be-tested device can be accurately obtained.

The state of charge (state of charge, SOC) of the to-be-tested device may be understood as a ratio of a remaining electricity quantity to a rated capacity of a battery of the to-be-tested device, and may be represented by a percentage. A value range of the state of charge is 0 to 100%. When the state of charge is 0, it indicates that the battery is fully discharged. When the state of charge is 100%, it indicates that the battery is fully charged.

In an example, the first device receives a state of charge reported by the to-be-tested device, to obtain the state of charge of the to-be-tested device. The state of charge closer to an endpoint value (0 or 100%) indicates higher reliability of the state of charge reported by the to-be-tested device, that is, the reported state of charge is closer to an actual state of charge, so that the first device can more accurately obtain the state of charge of the to-be-tested device. It may be understood that the state of charge reported by the to-be-tested device is 100%, and this is easy to implement during actual application. For example, when the to-be-tested device is charged to a fully-charged state, the state of charge reported by the to-be-tested device is 100%.

In a possible embodiment, the trigger condition includes: The to-be-tested device is in the fully-charged state.

The first device may detect a charging behavior of the to-be-tested device, and when detecting that the to-be-tested device is charged to the fully-charged state, determine that the to-be-tested device meets the trigger condition for the battery evaluation task. When a state of charge of the to-be-tested device in the fully-charged state is 100%, the state of charge is reliable.

According to this embodiment of this application, when the to-be-tested device is in the fully-charged state, the first device is triggered to perform the battery evaluation task, so that stability and reliability of a trigger occasion can be ensured, and the first device can start to perform the battery evaluation task at a stable and reliable occasion.

In a possible embodiment, the trigger condition includes: An accumulated mileage of the to-be-tested device is greater than a preset mileage, and/or an accumulated quantity of charging times of the to-be-tested device is greater than a preset quantity of times.

In an example, the trigger condition may include: An accumulated mileage of the to-be-tested device is greater than a preset mileage. The accumulated mileage of the to-be-tested device may be used to estimate a battery attenuation status of the to-be-tested device. A longer accumulated mileage indicates a higher probability of battery attenuation. If the accumulated mileage of the to-be-tested device is greater than the preset mileage, it may be considered that the to-be-tested device has been used for a long period, and consequently, the battery may be attenuated to an extent. When the to-be-tested device is in the fully-charged state and the accumulated mileage of the to-be-tested device is greater than the preset mileage, it is determined that the to-be-tested device meets the trigger condition for the battery evaluation task.

In another example, the trigger condition may include: An accumulated quantity of charging times of the to-be-tested device is greater than a preset quantity of times. The accumulated quantity of charging times of the to-be-tested device may be used to estimate a battery attenuation status of the to-be-tested device. A larger accumulated quantity of charging times indicates a higher probability of battery attenuation. If the accumulated quantity of charging times of the to-be-tested device is greater than the preset quantity of times, it may be considered that the to-be-tested device has been used for a long period, and consequently, the battery may be attenuated to an extent. When the to-be-tested device is in the fully-charged state and the accumulated quantity of charging times of the to-be-tested device is greater than the preset quantity of times, it is determined that the to-be-tested device meets the trigger condition for the battery evaluation task.

In still another example, the trigger condition may include: An accumulated mileage of the to-be-tested device is greater than a preset mileage, and an accumulated quantity of charging times of the to-be-tested device is greater than a preset quantity of times. When the to-be-tested device is in the fully-charged state, the accumulated mileage of the to-be-tested device is greater than the preset mileage, and the accumulated quantity of charging times of the to-be-tested device is greater than the preset quantity of times, it is determined that the to-be-tested device meets the trigger condition for the battery evaluation task.

It should be understood that specific values of the preset mileage and the preset quantity of times may be set based on an actual requirement. This is not limited in embodiments of this application.

According to this embodiment of this application, when the accumulated mileage of the to-be-tested device is greater than the preset mileage, and/or the accumulated quantity of charging times of the to-be-tested device is greater than the preset quantity of times, the battery of the to-be-tested device may be attenuated to an extent. In this case, it may be considered that it is necessary to evaluate the battery status of the to-be-tested device, and then the first device is triggered to perform the battery evaluation task. In this way, the first device can reduce unnecessary battery evaluation tasks, thereby saving computing resources.

In a possible embodiment, that the first device controls the to-be-tested device to perform the charging/discharging process corresponding to the battery evaluation task, and obtains the test data of the to-be-tested device in the charging/discharging process may specifically include: The first device controls the to-be-tested device to perform discharging, and obtains a first state of charge after the to-be-tested device ends discharging; and the first device obtains a second state of charge and an amount of charge of the to-be-tested device, where the second state of charge corresponds to a state of charge obtained when the to-be-tested device is charged until a charging end condition is met, and the amount of charge corresponds to an amount of charge of the to-be-tested device from ending discharging to being charged until the charging end condition is met. The test data includes the first state of charge, the second state of charge, and the amount of charge.

The first device controls the to-be-tested device to perform the charging/discharging process corresponding to the battery evaluation task. The charging/discharging process includes a discharging process and a charging process. The first device controls the to-be-tested device to perform discharging and then be charged, so that the to-be-tested device first performs discharging, and then be charged after ending discharging.

The first state of charge corresponds to the state of charge obtained after the to-be-tested device ends discharging, namely, a state of charge obtained when the to-be-tested device starts to be charged. The second state of charge corresponds to the state of charge obtained when the to-be-tested device is charged until the charging end condition is met, namely, a state of charge obtained when the to-be-tested device ends charging. The amount of charge corresponds to the amount of charge of the to-be-tested device from ending discharging to being charged until the charging end condition is met, namely, an amount of charge of the to-be-tested device in the charging process. The amount of charge may be obtained by using current data in the charging process according to an ampere-hour integral method.

According to this embodiment of this application, an available electricity quantity of the battery can be accurately reflected based on the first state of charge, the second state of charge, and the amount of charge, and the battery evaluation result with high precision is determined based on the available electricity quantity of the battery.

In a possible embodiment, that the first device controls the to-be-tested device to perform discharging may specifically include: The first device controls the to-be-tested device to perform self-discharge until a discharging end condition is met; and/or the first device sends first reminder information to the second device, where the first reminder information reminds the user to discharge the to-be-tested device until the discharging end condition is met.

The discharging end condition may be understood as a condition for triggering the to-be-tested device to end the discharging process. When the to-be-tested device discharges until the discharging end condition is met, the first device controls the to-be-tested device to end the discharging process.

In an example, the first device may control the to-be-tested device to perform self-discharge until the discharging end condition is met, that is, the to-be-tested device autonomously discharges without manual intervention until the discharging end condition is met. An electric vehicle is used as an example. For example, the electric vehicle may automatically turn on an in-vehicle air conditioner to perform autonomous discharging.

In another example, the first device may alternatively send first reminder information to the second device, where the first reminder information reminds the user to discharge the to-be-tested device until the discharging end condition is met. Correspondingly, the second device receives the first reminder information sent by the first device. The user may discharge the to-be-tested device by using the to-be-tested device. After the user ends using the to-be-tested device, the first device detects whether the to-be-tested device discharges until the discharging end condition is met. If it is detected that the discharging end condition is not met, it indicates that an amount of discharge of the to-be-tested device is insufficient. In this case, the first device may control the to-be-tested device to perform self-discharge, and the to-be-tested device continues to discharge until the discharging end condition is met.

According to this embodiment of this application, the first device may control the to-be-tested device to perform self-discharge until the discharging end condition is met. In this way, the discharging process of the to-be-tested device is automatically implemented without manual intervention. Alternatively, the first device may send the first reminder information to the second device, to remind the user to discharge the to-be-tested device until the discharging end condition is met. In this way, the user can determine, based on an actual requirement, whether to discharge the to-be-tested device by using the to-be-tested device. This helps effectively utilize a battery level of the to-be-tested device.

In a possible embodiment, the discharging end condition includes: A state of charge of the to-be-tested device is less than a first threshold.

The first threshold indicates a low state of charge. For example, the first threshold may be set to 20%. That the state of charge of the to-be-tested device is less than the first threshold may be understood as that the to-be-tested device discharges to a low state of charge. In this case, the state of charge is reliable.

In the discharging process of the to-be-tested device, the first device may detect the state of charge of the to-be-tested device. When detecting that the state of charge of the to-be-tested device is less than the first threshold, the first device determines that the to-be-tested device has discharged until the discharging end condition is met, to enable the to-be-tested device to end discharging.

According to this embodiment of this application, when the state of charge of the to-be-tested device is less than the first threshold, the to-be-tested device ends discharging, so that the to-be-tested device can be in a low-battery state after ending discharging. In this case, the state of charge of the to-be-tested device is used as a state of charge obtained when the to-be-tested device starts to be charged. This helps ensure reliability of the state of charge obtained when the to-be-tested device starts to be charged.

In a possible embodiment, the first device monitors parameter data of the to-be-tested device in a process of controlling the to-be-tested device to perform self-discharge. When detecting that an exception occurs in the parameter data, the first device sends alarm information to the second device, and controls the to-be-tested device to terminate self-discharge.

In a process in which the to-be-tested device performs self-discharge, the first device may monitor the parameter data of the to-be-tested device in real time. When the monitored parameter data exceeds a corresponding normal data range, it may be considered that the exception occurs in the parameter data. Optionally, the parameter data includes current data and/or temperature data of the battery.

When detecting that the exception occurs in the parameter data, the first device sends the alarm information to the second device, where the alarm information notifies the user of the exception. Correspondingly, the second device receives the alarm information sent by the first device. When detecting that the exception occurs in the parameter data, the first device may further control the to-be-tested device to terminate self-discharge, to avoid a possible security risk.

According to this embodiment of this application, in a process of controlling the to-be-tested device to perform self-discharge, when detecting that the exception occurs in the parameter data of the to-be-tested device, the first device sends the alarm information to the second device, so that the user can learn of the exception in a timely manner. In addition, the first device controls the to-be-tested device to terminate self-discharge, to help avoid a possible security risk in a timely manner.

In a possible embodiment, the obtaining the first state of charge after the to-be-tested device ends discharging may specifically include: The first device obtains a first open-circuit voltage of the to-be-tested device after the to-be-tested device ends discharging and stays idle for a first period; and the first device obtains the first state of charge based on a state of charge corresponding to the first open-circuit voltage.

There is a correspondence between a state of charge (state of charge, SOC) of the battery and an open-circuit voltage (open-circuit voltage, OCV). A state of charge corresponding to an open-circuit voltage of the to-be-tested device at a moment, namely, a state of charge of the to-be-tested device at the moment, may be obtained based on the open-circuit voltage and the correspondence. Optionally, the correspondence may be a relationship curve (an SOC-OCV curve) that is between a state of charge and an open-circuit voltage and that is obtained in advance through data fitting.

In a period after the to-be-tested device ends discharging, an open-circuit voltage of the to-be-tested device is unstable, and an accurate open-circuit voltage can be obtained after the to-be-tested device stays idle for a period. In this case, after the to-be-tested device ends discharging and stays idle for the first period, the first device obtains an open-circuit voltage of the to-be-tested device, where the open-circuit voltage is denoted as the first open-circuit voltage. The first period indicates a preset idle period, and the first open-circuit voltage may be considered as a real open-circuit voltage corresponding to a current state of charge. Then, the state of charge corresponding to the first open-circuit voltage is obtained as the first state of charge based on the first open-circuit voltage and the correspondence.

According to this embodiment of this application, the first open-circuit voltage after the to-be-tested device ends discharging and stays idle for a period is first obtained, and then the first state of charge is obtained based on the state of charge corresponding to the first open-circuit voltage. In this way, precision of the obtained first state of charge is high.

In a possible embodiment, that the first device obtains the second state of charge and the amount of charge of the to-be-tested device may be specifically: After the to-be-tested device ends discharging and stays idle for the first period, the first device controls the to-be-tested device to be charged, and obtains the second state of charge and the amount of charge of the to-be-tested device.

After the to-be-tested device ends discharging and stays idle for the first period, the first device controls the to-be-tested device to be charged until the charging end condition is met. The charging end condition may be understood as a condition for triggering the to-be-tested device to end the charging process. When the to-be-tested device is charged until the charging end condition is met, the first device controls the to-be-tested device to end the charging process.

The first device obtains the state of charge after the to-be-tested device ends discharging and stays idle for the first period, and uses the state of charge as the state of charge obtained when the to-be-tested device starts to be charged. The first device obtains the state of charge when the to-be-tested device is charged until the charging end condition is met, and uses the state of charge as the state of charge obtained when the to-be-tested device ends charging. The first device obtains current data of the to-be-tested device in the charging process, and performs ampere-hour integration by using the current data to obtain the amount of charge, where the amount of charge is used as an amount of charge of the to-be-tested device in the charging process.

According to this embodiment of this application, after the to-be-tested device ends discharging and stays idle for the first period, the first device controls the to-be-tested device to start to be charged. Because the state of charge after the to-be-tested device ends discharging and stays idle for the first period may be accurately obtained based on the open-circuit voltage, the state of charge is used as the state of charge obtained when the to-be-tested device starts to be charged. This can improve reliability of the state of charge obtained when the to-be-tested device starts to be charged.

In a possible embodiment, that the first device controls the to-be-tested device to be charged may be specifically: When the to-be-tested device is connected to a charging pile, the first device turns on a charging switch of the to-be-tested device, to enable the to-be-tested device to be charged until the charging end condition is met.

When the to-be-tested device is connected to the charging pile, it indicates that the to-be-tested device is ready for charging. In this case, the first device turns on the charging switch of the to-be-tested device, so that the to-be-tested device can be charged.

According to this embodiment of this application, when the to-be-tested device is connected to the charging pile, the first device may enable, by turning on the charging switch of the to-be-tested device, the to-be-tested device to be charged until the charging end condition is met. In this way, the charging process of the to-be-tested device is automatically implemented without manual intervention.

In a possible embodiment, that the first device controls the to-be-tested device to be charged may be specifically: The first device sends second reminder information to the second device when the to-be-tested device is connected to a charging pile, where the second reminder information reminds the user to turn on a charging switch of the to-be-tested device, to enable the to-be-tested device to be charged until the charging end condition is met.

When the to-be-tested device is connected to the charging pile, the first device may alternatively send the second reminder information to the second device, where the second reminder information reminds the user to turn on the charging switch of the to-be-tested device. The user may turn on the charging switch of the to-be-tested device by using the second device, so that the to-be-tested device starts to be charged. Correspondingly, the second device receives the second reminder information sent by the first device, and the second device turns on the charging switch of the to-be-tested device, to enable the to-be-tested device to be charged until the charging end condition is met.

According to this embodiment of this application, when the to-be-tested device is connected to the charging pile, the first device may send the second reminder information to the second device, to remind the user to turn on the charging switch of the to-be-tested device. In this way, a requirement of the user for controlling a charging start moment can be met.

In a possible embodiment, the charging end condition includes: A state of charge of the to-be-tested device can be accurately obtained.

The first device may receive a state of charge reported by the to-be-tested device, to obtain the state of charge of the to-be-tested device. The state of charge closer to 100% indicates higher reliability of the state of charge reported by the to-be-tested device, that is, the reported state of charge is closer to an actual state of charge, so that the first device can more accurately obtain the state of charge of the to-be-tested device.

In a possible embodiment, the charging end condition includes: A state of charge of the to-be-tested device is greater than a second threshold.

The second threshold indicates a high state of charge. For example, the second threshold may be set to 90%. That the state of charge of the to-be-tested device is greater than the second threshold may be understood as that the to-be-tested device is charged to a high state of charge. In this case, the state of charge is reliable.

In the charging process of the to-be-tested device, the first device may detect the state of charge of the to-be-tested device. When detecting that the state of charge of the to-be-tested device is greater than the second threshold, the second device determines that the to-be-tested device has been charged until the charging end condition is met, to enable the to-be-tested device to end charging.

A state of charge when the to-be-tested device ends charging may be obtained based on the open-circuit voltage. Specifically, after the to-be-tested device ends charging and stays idle for a second period, the first device obtains a second open-circuit voltage of the to-be-tested device, and obtains, based on a state of charge corresponding to the second open-circuit voltage, the state of charge obtained when the to-be-tested device ends charging.

In a possible embodiment, the charging end condition includes: The to-be-tested device reaches the fully-charged state.

When a state of charge of the to-be-tested device that reaches the fully-charged state is 100%, the state of charge is reliable. In the charging process of the to-be-tested device, the first device may detect whether the to-be-tested device reaches the fully-charged state. When detecting that the to-be-tested device reaches the fully-charged state, the first device determines that the to-be-tested device has been charged until the charging end condition is met, to enable the to-be-tested device to end charging.

According to this embodiment of this application, the to-be-tested device ends charging when reaching the fully-charged state, so that the state of charge obtained when the to-be-tested device ends charging is 100%, and the state of charge is reliable. This helps ensure reliability of the state of charge obtained when the to-be-tested device ends charging.

In a possible embodiment, that the first device controls the to-be-tested device to be charged further includes: When the to-be-tested device is not connected to the charging pile, the first device sends third reminder information to the second device, where the third reminder information reminds the user to connect the to-be-tested device to the charging pile.

If the to-be-tested device is not connected to the charging pile, it indicates that the to-be-tested device is not ready for charging. In this case, the to-be-tested device needs to be connected to the charging pile, and then the charging switch of the to-be-tested device is turned on, so that the to-be-tested device can be charged.

When the to-be-tested device is not connected to the charging pile, the first device sends the third reminder information to the second device, where the third reminder information reminds the user to connect the to-be-tested device to the charging pile. Correspondingly, the second device receives the third reminder information sent by the first device.

According to this embodiment of this application, when the to-be-tested device is not connected to the charging pile, the first device sends the third reminder information to the second device, to remind the user to connect the to-be-tested device to the charging pile. In this way, the charging switch of the to-be-tested device is turned on when the to-be-tested device is connected to the charging pile.

In a possible embodiment, that the first device determines the battery evaluation result based on the test data may specifically include: The first device determines a maximum available electricity quantity of the to-be-tested device based on the amount of charge and a difference between the first state of charge and the second state of charge; and the first device determines a battery state of health of the to-be-tested device based on a ratio of the maximum available electricity quantity of the to-be-tested device to a rated electricity quantity of the to-be-tested device, where the battery evaluation result includes the battery state of health of the to-be-tested device.

The maximum available electricity quantity of the to-be-tested device may be calculated as follows: Qₘₐₓ=Q_{c}/(SOC₂-SOC₁), where Qₘₐₓ, SOC₁, SOC₂, and Qc respectively indicate the maximum available electricity quantity, the first state of charge, the second state of charge, and the amount of charge of the to-be-tested device. The battery state of health of the to-be-tested device may be calculated as follows: SOH=Qₘₐₓ/Q₀, where SOH and Qₒ respectively indicate the battery state of health and the rated electricity quantity of the to-be-tested device.

According to this embodiment of this application, the first device first evaluates the maximum available electricity quantity of the to-be-tested device based on the amount of charge and the difference between the first state of charge obtained when the to-be-tested device starts charging and the second state of charge obtained when the to-be-tested device ends charging, and then evaluates the battery state of health of the to-be-tested device based on the ratio of the maximum available electricity quantity of the to-be-tested device to the rated electricity quantity of the to-be-tested device. This manner of evaluating the battery state of health uses a "first" principle, that is, the battery state of health is evaluated by using a physical quantity directly related to the battery state of health and a logical relationship thereof, which is more interpretable. In this way, the evaluated battery state of health has high precision, and an evaluated value is close to a real value.

The foregoing describes in detail the methods in embodiments of this application. The following provides an apparatus for implementing any method in embodiments of this application.

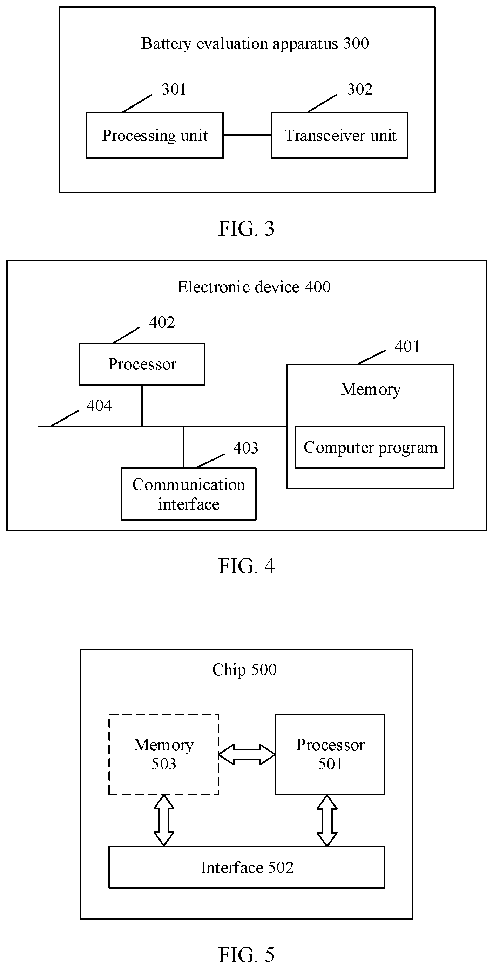

FIG. 3 is a diagram of a structure of a battery evaluation apparatus according to an embodiment of this application.

As shown in FIG. 3, the battery evaluation apparatus 300 may include a processing unit 301 and a transceiver unit 302. The processing unit 301 and the transceiver unit 302 may be software, hardware, or a combination of software and hardware.

The transceiver unit 302 may implement a sending function and/or a receiving function, and the transceiver unit 302 may also be described as a communication unit. The transceiver unit 302 may alternatively be a unit integrating an obtaining unit and a sending unit. The obtaining unit is configured to implement a receiving function, and the sending unit is configured to implement a sending function. Optionally, the transceiver unit 302 may be configured to receive information sent by another apparatus, and may be further configured to send information to another apparatus.

In a possible design, the battery evaluation apparatus 300 may correspond to the first device in the method embodiment shown in FIG. 2. For example, the battery evaluation apparatus 300 may be the first device, or may be a chip in the first device. The battery evaluation apparatus 300 may include units for performing operations performed by the first device in the method embodiment shown in FIG. 2. In addition, the units in the battery evaluation apparatus 300 are separately configured to implement the operations performed by the first device in the method embodiment shown in FIG. 2. The units are described as follows.

The processing unit 301 is configured to: when a to-be-tested device meets a trigger condition for a battery evaluation task, control the to-be-tested device to perform a charging/discharging process corresponding to the battery evaluation task, obtain test data of the to-be-tested device in the charging/discharging process, and determine a battery evaluation result based on the test data.

The transceiver unit 302 is configured to send the battery evaluation result to a second device.

In a possible implementation, when controlling the to-be-tested device to perform the charging/discharging process corresponding to the battery evaluation task, the processing unit 301 is specifically configured to: when obtaining authorization for performing the battery evaluation task, control the to-be-tested device to perform the charging/discharging process corresponding to the battery evaluation task.

In a possible implementation, the transceiver unit 302 is further configured to: send request information to the second device when obtaining no authorization for performing the battery evaluation task; and receive authorization information sent by the second device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, when controlling the to-be-tested device to perform the charging/discharging process corresponding to the battery evaluation task, and obtaining the test data of the to-be-tested device in the charging/discharging process, the processing unit 301 is specifically configured to: control the to-be-tested device to perform discharging, and obtain a first state of charge after the to-be-tested device ends discharging; and obtain a second state of charge and an amount of charge of the to-be-tested device, where the second state of charge corresponds to a state of charge obtained when the to-be-tested device is charged until a charging end condition is met, and the amount of charge corresponds to an amount of charge of the to-be-tested device from ending discharging to being charged until the charging end condition is met. The test data includes the first state of charge, the second state of charge, and the amount of charge.

In a possible implementation, when controlling the to-be-tested device to perform discharging, the processing unit 301 is specifically configured to control the to-be-tested device to perform self-discharge until a discharging end condition is met.

In a possible implementation, the transceiver unit 302 is further configured to send first reminder information to the second device, where the first reminder information reminds the user to discharge the to-be-tested device until the discharging end condition is met.

In a possible implementation, the discharging end condition includes: A state of charge of the to-be-tested device is less than a first threshold.

In a possible implementation, the processing unit 301 is further configured to: monitor parameter data of the to-be-tested device in a process of controlling the to-be-tested device to perform self-discharge, and control, when detecting that an exception occurs in the parameter data, the to-be-tested device to terminate self-discharge. The transceiver unit 302 is further configured to send alarm information to the second device when detecting that the exception occurs in the parameter data.

In a possible implementation, when obtaining the first state of charge after the to-be-tested device ends discharging, the processing unit 301 is specifically configured to: after the to-be-tested device ends discharging and stays idle for a first period, obtain a first open-circuit voltage of the to-be-tested device; and obtain the first state of charge based on a state of charge corresponding to the first open-circuit voltage.

In a possible implementation, when obtaining the second state of charge and the amount of charge of the to-be-tested device, the processing unit 301 is specifically configured to: after the to-be-tested device ends discharging and stays idle for the first period, control the to-be-tested device to be charged, and obtain the second state of charge and the amount of charge of the to-be-tested device.

In a possible implementation, when controlling the to-be-tested device to be charged, the processing unit 301 is specifically configured to: when the to-be-tested device is connected to a charging pile, turn on a charging switch of the to-be-tested device, to enable the to-be-tested device to be charged until the charging end condition is met.

In a possible implementation, the transceiver unit 302 is further configured to send second reminder information to the second device when the to-be-tested device is connected to the charging pile, where the second reminder information reminds the user to turn on a charging switch of the to-be-tested device, to enable the to-be-tested device to be charged until the charging end condition is met.

In a possible implementation, the charging end condition includes: A state of charge of the to-be-tested device can be accurately obtained.

In a possible implementation, the charging end condition includes: The to-be-tested device reaches the fully-charged state.

In a possible implementation, the transceiver unit 302 is further configured to: when the to-be-tested device is not connected to the charging pile, send third reminder information to the second device, where the third reminder information reminds the user to connect the to-be-tested device to the charging pile.

In a possible embodiment, when determining the battery evaluation result based on the test data, the processing unit 301 is specifically configured to: determine a maximum available electricity quantity of the to-be-tested device based on the amount of charge and a difference between the first state of charge and the second state of charge; and determine, a battery state of health of the to-be-tested device based on a ratio of the maximum available electricity quantity of the to-be-tested device to a rated electricity quantity of the to-be-tested device, where the battery evaluation result includes the battery state of health of the to-be-tested device.

In another possible design, the battery evaluation apparatus 300 may correspond to the second device in the method embodiment shown in FIG. 2. For example, the battery evaluation apparatus 300 may be the second device, or may be a chip in the second device. The battery evaluation apparatus 300 may include units for performing operations performed by the second device in the method embodiment shown in FIG. 2. In addition, the units in the battery evaluation apparatus 300 are separately configured to implement the operations performed by the second device in the method embodiment shown in FIG. 2. The units are described as follows.

The transceiver unit 302 is configured to receive a battery evaluation result sent by a first device, where the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

In a possible implementation, the transceiver unit 302 is further configured to: receive request information sent by the first device when the first device obtains no authorization for performing the battery evaluation task; and send authorization information to the first device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, the transceiver unit 302 is further configured to receive first reminder information sent by the first device when the first device controls the to-be-tested device to perform discharging, where the first reminder information reminds a user to discharge the to-be-tested device until a discharging end condition is met.

In a possible implementation, the discharging end condition includes: A state of charge of the to-be-tested device is less than a first threshold.

In a possible implementation, the transceiver unit 302 is further configured to receive alarm information sent by the first device when the first device detects, in a process of controlling the to-be-tested device to perform self-discharge, that an exception occurs in parameter data of the to-be-tested device.

In a possible implementation, the transceiver unit 302 is further configured to: receive second reminder information sent by the first device when the first device controls the to-be-tested device to be charged and the to-be-tested device is connected to a charging pile, where the second reminder information reminds a user to turn on a charging switch of the to-be-tested device, to enable the to-be-tested device to be charged until a charging end condition is met. The processing unit 301 is configured to turn on the charging switch of the to-be-tested device, to enable the to-be-tested device to be charged until the charging end condition is met.

In a possible implementation, the charging end condition includes: A state of charge of the to-be-tested device can be accurately obtained.

In a possible implementation, the charging end condition includes: The to-be-tested device reaches the fully-charged state.

In a possible implementation, the transceiver unit 302 is further configured to: receive third reminder information sent by the first device when the first device controls the to-be-tested device to be charged and the to-be-tested device is not connected to the charging pile, where the third reminder information reminds the user to connect the to-be-tested device to the charging pile.

In a possible implementation, the test data includes a first state of charge, a second state of charge, and an amount of charge. The first state of charge corresponds to a state of charge obtained after the to-be-tested device ends discharging, the second state of charge corresponds to a state of charge obtained when the to-be-tested device is charged until the charging end condition is met, and the amount of charge corresponds to an amount of charge of the to-be-tested device from ending discharging to being charged until the charging end condition is met.

In a possible implementation, the battery evaluation result includes a battery state of health of the to-be-tested device, and the battery state of health of the to-be-tested device is determined based on a ratio of a maximum available electricity quantity of the to-be-tested device to a rated electricity quantity of the to-be-tested device. The maximum available electricity quantity of the to-be-tested device is determined based on the amount of charge and a difference between the first state of charge and the second state of charge.

According to this embodiment of this application, the units in the apparatus shown in FIG. 3 may be separately or all combined into one or more other units, or one or more units in the apparatus may be further split into a plurality of units with more detailed functions. This can implement a same operation without affecting implementations of technical effects of this embodiment of this application. The foregoing units are obtained through division based on logical functions. During actual application, a function of one unit may be implemented by a plurality of units, or functions of a plurality of units are implemented by one unit. In other embodiments of this application, an electronic device may further include other units. During actual application, the functions may alternatively be implemented with assistance of the other units, and may be implemented by a plurality of units in collaboration.

It should be noted that, for implementations of the units, refer to corresponding descriptions of the method embodiment shown in FIG. 2.

For implementations and beneficial effects of the units in the battery evaluation apparatus, refer to corresponding descriptions in the foregoing method embodiment. Details are not described herein again.

FIG. 4 is a diagram of a structure of an electronic device 400 according to an embodiment of this application. The electronic device 400 may include a memory 401 and a processor 402. Further, optionally, the electronic device 400 may further include a communication interface 403 and a bus 404. The memory 401, the processor 402, and the communication interface 403 implement mutual communication connections through the bus 404. The communication interface 403 is configured to exchange data with another device.

The memory 401 is configured to provide storage space, and the storage space may store data such as an operating system and a computer program. The memory 401 includes but is not limited to a random access memory (random access memory, RAM), a read-only memory (read-only memory, ROM), an erasable programmable read-only memory (erasable programmable read-only memory, EPROM), or a compact disc read-only memory (compact disc read-only memory, CD-ROM).

The processor 402 is a module that performs an arithmetic operation and a logical operation, and may be one or a combination of processing modules such as a central processing unit (central processing unit, CPU), a graphics processing unit (graphics processing unit, GPU), or a microprocessor unit (microprocessor unit, MPU). The processor 402 may alternatively be another general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or a transistor logic device, a discrete hardware component, or the like. The general-purpose processor may be a microprocessor, or the processor may be any conventional processor or the like.

In a possible design, the electronic device 400 may correspond to the first device in the method embodiment shown in FIG. 2. For example, the electronic device 400 may be the first device, or may be a chip in the first device. The electronic device 400 may include components configured to perform operations performed by the first device in the method embodiment. In addition, the components in the electronic device 400 are separately configured to implement the operations performed by the first device in the method embodiment, and the processor 402 invokes the computer program stored in the memory 401, to perform the battery evaluation method shown in FIG. 2. Details may be described below.

When a to-be-tested device meets a trigger condition for a battery evaluation task, the first device controls the to-be-tested device to perform a charging/discharging process corresponding to the battery evaluation task, and obtains test data of the to-be-tested device in the charging/discharging process; the first device determines a battery evaluation result based on the test data; and the first device sends the battery evaluation result to a second device.

In a possible implementation, that the first device controls the to-be-tested device to perform the charging/discharging process corresponding to the battery evaluation task includes: When obtaining authorization for performing the battery evaluation task, the first device controls the to-be-tested device to perform the charging/discharging process corresponding to the battery evaluation task.

In a possible implementation, the method further includes: The first device sends request information to the second device when obtaining no authorization for performing the battery evaluation task; and the first device receives authorization information sent by the second device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, that the first device controls the to-be-tested device to perform the charging/discharging process corresponding to the battery evaluation task, and obtains the test data of the to-be-tested device in the charging/discharging process includes: The first device controls the to-be-tested device to perform discharging, and obtains a first state of charge after the to-be-tested device ends discharging; and the first device obtains a second state of charge and an amount of charge of the to-be-tested device, where the second state of charge corresponds to a state of charge obtained when the to-be-tested device is charged until a charging end condition is met, and the amount of charge corresponds to an amount of charge of the to-be-tested device from ending discharging to being charged until the charging end condition is met. The test data includes the first state of charge, the second state of charge, and the amount of charge.

In a possible implementation, that the first device controls the to-be-tested device to perform discharging includes: The first device controls the to-be-tested device to perform self-discharge until a discharging end condition is met; and/or the first device sends first reminder information to the second device, where the first reminder information reminds a user to discharge the to-be-tested device until the discharging end condition is met.

In a possible implementation, the discharging end condition includes: A state of charge of the to-be-tested device is less than a first threshold.

In a possible implementation, the method further includes: The first device monitors parameter data of the to-be-tested device in a process of controlling the to-be-tested device to perform self-discharge. When detecting that an exception occurs in the parameter data, the first device sends alarm information to the second device, and controls the to-be-tested device to terminate self-discharge.

In a possible implementation, the obtaining the first state of charge after the to-be-tested device ends discharging includes: After the to-be-tested device ends discharging and stays idle for a first period, the first device obtains a first open-circuit voltage of the to-be-tested device; and the first device obtains the first state of charge based on a state of charge corresponding to the first open-circuit voltage.

In a possible implementation, that the first device obtains the second state of charge and the amount of charge of the to-be-tested device includes: After the to-be-tested device ends discharging and stays idle for the first period, the first device controls the to-be-tested device to be charged, and obtains the second state of charge and the amount of charge of the to-be-tested device.

In a possible implementation, that the first device controls the to-be-tested device to be charged includes: When the to-be-tested device is connected to a charging pile, the first device turns on a charging switch of the to-be-tested device, to enable the to-be-tested device to be charged until the charging end condition is met.

In a possible implementation, that the first device controls the to-be-tested device to be charged includes: The first device sends second reminder information to the second device when the to-be-tested device is connected to the charging pile, where the second reminder information reminds the user to turn on the charging switch of the to-be-tested device, to enable the to-be-tested device to be charged until the charging end condition is met.

In a possible implementation, the charging end condition includes: A state of charge of the to-be-tested device can be accurately obtained.

In a possible implementation, the charging end condition includes: The to-be-tested device reaches the fully-charged state.

In a possible implementation, that the first device controls the to-be-tested device to be charged further includes: When the to-be-tested device is not connected to the charging pile, the first device sends third reminder information to the second device, where the third reminder information reminds the user to connect the to-be-tested device to the charging pile.

In a possible implementation, that the first device determines the battery evaluation result based on the test data includes: The first device determines a maximum available electricity quantity of the to-be-tested device based on the amount of charge and a difference between the first state of charge and the second state of charge; and the first device determines a battery state of health of the to-be-tested device based on a ratio of the maximum available electricity quantity of the to-be-tested device to a rated electricity quantity of the to-be-tested device, where the battery evaluation result includes the battery state of health of the to-be-tested device.

For specific content of the method performed by the processor 402, refer to FIG. 2. Details are not described herein again.

Correspondingly, the processor 402 invokes the computer program stored in the memory 401, and may be further configured to perform the method steps performed by the units in the battery evaluation apparatus 300 shown in FIG. 3. For specific content, refer to FIG. 3. Details are not described herein again.

In another possible design, the electronic device 400 may correspond to the second device in the method embodiment shown in FIG. 2. For example, the electronic device 400 may be the second device, or may be a chip in the second device. The electronic device 400 may include components configured to perform operations performed by the second device in the method embodiment. In addition, the components in the electronic device 400 are separately configured to implement the operations performed by the second device in the method embodiment, and the processor 402 invokes the computer program stored in the memory 401, to perform the battery evaluation method shown in FIG. 2. Details may be described below.

The second device receives a battery evaluation result sent by a first device, where the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

In a possible implementation, the method further includes: The second device receives request information sent by the first device when the first device obtains no authorization for performing the battery evaluation task; and the second device sends authorization information to the first device, where the authorization information is used to authorize the first device to perform the battery evaluation task.

In a possible implementation, the authorization information includes a quantity of authorization times and/or an authorization period.

In a possible implementation, the trigger condition includes: A state of charge of the to-be-tested device can be accurately obtained.

In a possible implementation, the trigger condition includes: The to-be-tested device is in a fully-charged state.

In a possible implementation, the trigger condition includes: An accumulated mileage of the to-be-tested device is greater than a preset mileage, and/or an accumulated quantity of charging times of the to-be-tested device is greater than a preset quantity of times.

In a possible implementation, the method further includes: The second device receives first reminder information sent by the first device when the first device controls the to-be-tested device to perform discharging, where the first reminder information reminds a user to discharge the to-be-tested device until a discharging end condition is met.

In a possible implementation, the discharging end condition includes: A state of charge of the to-be-tested device is less than a first threshold.

In a possible implementation, the method further includes: The second device receives alarm information sent by the first device when the first device detects, in a process of controlling the to-be-tested device to perform self-discharge, that an exception occurs in parameter data of the to-be-tested device.

In a possible implementation, the method further includes: The second device receives second reminder information sent by the first device when the first device controls the to-be-tested device to be charged and the to-be-tested device is connected to a charging pile, where the second reminder information reminds a user to turn on a charging switch of the to-be-tested device, to enable the to-be-tested device to be charged until a charging end condition is met; and the second device turns on the charging switch of the to-be-tested device, to enable the to-be-tested device to be charged until the charging end condition is met.

In a possible implementation, the charging end condition includes: A state of charge of the to-be-tested device can be accurately obtained.

In a possible implementation, the charging end condition includes: The to-be-tested device reaches the fully-charged state.

In a possible implementation, the method further includes: The second device receives third reminder information sent by the first device when the first device controls the to-be-tested device to be charged and the to-be-tested device is not connected to the charging pile, where the third reminder information reminds the user to connect the to-be-tested device to the charging pile.

In a possible implementation, the test data includes a first state of charge, a second state of charge, and an amount of charge. The first state of charge corresponds to a state of charge obtained after the to-be-tested device ends discharging, the second state of charge corresponds to a state of charge obtained when the to-be-tested device is charged until the charging end condition is met, and the amount of charge corresponds to an amount of charge of the to-be-tested device from ending discharging to being charged until the charging end condition is met.

In a possible implementation, the battery evaluation result includes a battery state of health of the to-be-tested device, and the battery state of health of the to-be-tested device is determined based on a ratio of a maximum available electricity quantity of the to-be-tested device to a rated electricity quantity of the to-be-tested device. The maximum available electricity quantity of the to-be-tested device is determined based on the amount of charge and a difference between the first state of charge and the second state of charge.

For specific content of the method performed by the processor 402, refer to FIG. 2. Details are not described herein again.

Correspondingly, the processor 402 invokes the computer program stored in the memory 401, and may be further configured to perform the method steps performed by the units in the battery evaluation apparatus 300 shown in FIG. 3. For specific content, refer to FIG. 3. Details are not described herein again.

For a case in which the electronic device may be a chip or a chip system, refer to a diagram of a structure of a chip shown in FIG. 5.

As shown in FIG. 5, the chip 500 includes a processor 501 and an interface 502. There may be one or more processors 501, and there may be a plurality of interfaces 502. It should be noted that functions corresponding to the processor 501 and the interface 502 may be implemented by using a hardware design, or may be implemented by using a software design, or may be implemented by using a combination of software and hardware. This is not limited herein.

Optionally, the chip 500 may further include a memory 503, and the memory 503 is configured to store necessary program instructions and data.

In this application, the processor 501 may be configured to: invoke, from the memory 503, a program for implementing, on the electronic device, the battery evaluation method provided in one or more embodiments of this application, and execute instructions included in the program. The interface 502 may be configured to output an execution result of the processor 501. In this application, the interface 502 may be specifically configured to output each message or information of the processor 501.

For the battery evaluation method provided in one or more embodiments of this application, refer to the foregoing embodiments shown in FIG. 2. Details are not described herein again.

According to the method provided in embodiments of this application, an embodiment of this application further provides a computer-readable storage medium. The computer-readable storage medium stores a computer program. When the computer program is run on one or more processors, the method shown in FIG. 2 may be implemented.

According to the method provided in embodiments of this application, an embodiment of this application further provides a computer program product. The computer program product includes a computer program. When the computer program is run on a processor, the method shown in FIG. 2 may be implemented.

An embodiment of this application further provides a vehicle end. The vehicle end includes at least one battery evaluation apparatus 300, electronic device 400, or chip 500.

An embodiment of this application further provides a system. The system includes a vehicle end and at least one battery evaluation apparatus 300, electronic device 400, or chip 500, configured to perform steps performed by a corresponding device in any embodiment in FIG. 2.

An embodiment of this application further provides a system. The system includes a first device and a second device. The first device is configured to perform the steps performed by the first device in any embodiment in FIG. 2, and the second device is configured to perform the steps performed by the second device in any embodiment in FIG. 2.

It may be understood that the memory in embodiments of this application may be a volatile memory or a nonvolatile memory, or may include a volatile memory and a nonvolatile memory. The nonvolatile memory may be a hard disk drive (hard disk drive, HDD), a solid-state drive (solid-state drive, SSD), a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example, but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM). It should be noted that the memory described in this specification aims to include but is not limited to these memories and any memory of another proper type.

All or some of the foregoing embodiments may be implemented by using software, hardware, firmware, or any combination thereof. When software is used for implementation, all or some of embodiments may be implemented in a form of computer program product. The computer program product includes one or more computer programs or instructions. When the computer programs or the instructions are loaded and executed on a computer, all or some of procedures or functions in embodiments of this application are executed. The computer may be a general-purpose computer, a dedicated computer, a computer network, a network device, user equipment, or another programmable apparatus. The computer programs or the instructions may be stored in a computer-readable storage medium, or may be transmitted from a computer-readable storage medium to another computer-readable storage medium. For example, the computer programs or the instructions may be transmitted from a website, computer, server, or data center to another website, computer, server, or data center in a wired or wireless manner. The computer-readable storage medium may be any usable medium accessible by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

It may be understood that, in embodiments of this application, the electronic device may perform some or all steps in embodiments of this application. These steps or operations are merely examples. In embodiments of this application, other operations or variations of various operations may be performed. In addition, the steps may be performed in a sequence different from a sequence presented in embodiments of this application, and not all the operations in embodiments of this application may be performed.

A person of ordinary skill in the art may be aware that units and algorithm steps in the examples described with reference to embodiments provided in this specification may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it shall not be considered that the implementation goes beyond the scope of this application.

It may be clearly understood by a person skilled in the art that, for the purpose of convenient and brief description, for detailed working processes of the foregoing system, apparatus, and units, refer to a corresponding process in the foregoing method embodiment. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate components may or may not be physically separate, and parts displayed as units may or may not be physical units, may be located in one location, or may be distributed on a plurality of network units. Some or all of the units may be selected based on an actual requirement to achieve the objectives of the solutions in embodiments.

In addition, functional units in embodiments of this application may be integrated into one processing unit, or each of the units may exist alone physically, or two or more units may be integrated into one unit.

When the functions are implemented in a form of software functional unit and sold or used as an independent product, the functions may be stored in a computer-readable storage medium. Based on such an understanding, the technical solutions of this application essentially, or the part contributing to the technology, or some of the technical solutions may be implemented in a form of software product. The computer software product is stored in a storage medium, and includes several instructions for instructing a computer device (which may be a personal computer, a server, a network device, or the like) to perform all or some of the steps in the method described in embodiments of this application. The foregoing storage medium includes any medium that can store program code, for example, a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A battery evaluation method, comprising:
when a to-be-tested device meets a trigger condition for a battery evaluation task, controlling, by a first device, the to-be-tested device to perform a charging/discharging process corresponding to the battery evaluation task, and obtaining test data of the to-be-tested device in the charging/discharging process;
determining, by the first device, a battery evaluation result based on the test data; and
sending, by the first device, the battery evaluation result to a second device.

2. The method according to claim 1, wherein controlling, by the first device, the to-be-tested device to perform the charging/discharging process corresponding to the battery evaluation task comprises:
when obtaining authorization for performing the battery evaluation task, controlling, by the first device, the to-be-tested device to perform the charging/discharging process corresponding to the battery evaluation task.

3. The method according to claim 2, wherein the method further comprises:
sending, by the first device, request information to the second device when obtaining no authorization for performing the battery evaluation task; and
receiving, by the first device, authorization information sent by the second device, wherein the authorization information is used to authorize the first device to perform the battery evaluation task.

4. The method according to claim 3, wherein the authorization information comprises a quantity of authorization times and/or an authorization period.

5. The method according to any one of claims 1 to 4, wherein the trigger condition comprises: the to-be-tested device is in a fully-charged state.

6. The method according to any one of claims 1 to 5, wherein the trigger condition comprises: an accumulated mileage of the to-be-tested device is greater than a preset mileage, and/or an accumulated quantity of charging times of the to-be-tested device is greater than a preset quantity of times.

7. The method according to claim 5 or 6, wherein controlling, by the first device, the to-be-tested device to perform the charging/discharging process corresponding to the battery evaluation task, and obtaining the test data of the to-be-tested device in the charging/discharging process comprises:
controlling, by the first device, the to-be-tested device to perform discharging, and obtaining a first state of charge after the to-be-tested device ends discharging; and
obtaining, by the first device, a second state of charge and an amount of charge of the to-be-tested device, wherein the second state of charge corresponds to a state of charge obtained when the to-be-tested device is charged until a charging end condition is met, and the amount of charge corresponds to an amount of charge of the to-be-tested device from ending discharging to being charged until the charging end condition is met, wherein
the test data comprises the first state of charge, the second state of charge, and the amount of charge.

8. The method according to claim 7, wherein controlling, by the first device, the to-be-tested device to perform discharging comprises:
controlling, by the first device, the to-be-tested device to perform self-discharge until a discharging end condition is met; and/or
sending, by the first device, first reminder information to the second device, wherein the first reminder information reminds a user to discharge the to-be-tested device until the discharging end condition is met.

9. The method according to claim 8, wherein the discharging end condition comprises: a state of charge of the to-be-tested device is less than a first threshold.

10. The method according to claim 8 or 9, wherein the method further comprises:
monitoring, by the first device, parameter data of the to-be-tested device in a process of controlling the to-be-tested device to perform self-discharge; and
when detecting that an exception occurs in the parameter data, sending, by the first device, alarm information to the second device, and controlling the to-be-tested device to terminate self-discharge.

11. The method according to any one of claims 7 to 10, wherein obtaining the first state of charge after the to-be-tested device ends discharging comprises:
obtaining, by the first device, a first open-circuit voltage of the to-be-tested device after the to-be-tested device ends discharging and stays idle for a first period; and
obtaining, by the first device, the first state of charge based on a state of charge corresponding to the first open-circuit voltage.

12. The method according to any one of claims 7 to 11, wherein obtaining, by the first device, the second state of charge and the amount of charge of the to-be-tested device comprises:
after the to-be-tested device ends discharging and stays idle for the first period, controlling, by the first device, the to-be-tested device to be charged, and obtaining the second state of charge and the amount of charge of the to-be-tested device.

13. The method according to any one of claims 7 to 12, wherein controlling, by the first device, the to-be-tested device to be charged comprises:
when the to-be-tested device is connected to a charging pile,
turning on, by the first device, a charging switch of the to-be-tested device, to enable the to-be-tested device to be charged until the charging end condition is met; or
sending, by the first device, second reminder information to the second device, wherein the second reminder information reminds the user to turn on a charging switch of the to-be-tested device, to enable the to-be-tested device to be charged until the charging end condition is met.

14. The method according to claim 13, wherein the charging end condition comprises: the to-be-tested device reaches the fully-charged state.

15. The method according to any one of claims 7 to 14, wherein controlling, by the first device, the to-be-tested device to be charged further comprises:
when the to-be-tested device is not connected to the charging pile, sending, by the first device, third reminder information to the second device, wherein the third reminder information reminds the user to connect the to-be-tested device to the charging pile.

16. The method according to any one of claims 7 to 15, wherein determining, by the first device, the battery evaluation result based on the test data comprises:
determining, by the first device, a maximum available electricity quantity of the to-be-tested device based on the amount of charge and a difference between the first state of charge and the second state of charge; and
determining, by the first device, a battery state of health of the to-be-tested device based on a ratio of the maximum available electricity quantity of the to-be-tested device to a rated electricity quantity of the to-be-tested device, wherein
the battery evaluation result comprises the battery state of health of the to-be-tested device.

17. A battery evaluation method, comprising:
receiving, by a second device, a battery evaluation result sent by a first device, wherein the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

18. The method according to claim 17, wherein the method further comprises:
receiving, by the second device, request information sent by the first device when the first device obtains no authorization for performing the battery evaluation task; and
sending, by the second device, authorization information to the first device, wherein the authorization information is used to authorize the first device to perform the battery evaluation task.

19. The method according to claim 18, wherein the authorization information comprises a quantity of authorization times and/or an authorization period.

20. The method according to any one of claims 17 to 19, wherein the method further comprises:
receiving, by the second device, first reminder information sent by the first device when the first device controls the to-be-tested device to perform discharging, wherein the first reminder information reminds a user to discharge the to-be-tested device until a discharging end condition is met.

21. The method according to any one of claims 17 to 20, wherein the method further comprises:
receiving, by the second device, alarm information sent by the first device when the first device detects, in a process of controlling the to-be-tested device to perform self-discharge, that an exception occurs in parameter data of the to-be-tested device.

22. The method according to any one of claims 17 to 21, wherein the method further comprises:
receiving, by the second device, second reminder information sent by the first device when the first device controls the to-be-tested device to be charged and the to-be-tested device is connected to a charging pile, wherein the second reminder information reminds the user to turn on a charging switch of the to-be-tested device, to enable the to-be-tested device to be charged until a charging end condition is met; and
turning on, by the second device, the charging switch of the to-be-tested device, to enable the to-be-tested device to be charged until the charging end condition is met.

23. The method according to any one of claims 17 to 22, wherein the method further comprises:
receiving, by the second device, third reminder information sent by the first device when the first device controls the to-be-tested device to be charged and the to-be-tested device is not connected to the charging pile, wherein the third reminder information reminds the user to connect the to-be-tested device to the charging pile.

24. A battery evaluation apparatus, comprising:
a processing unit, configured to: when a to-be-tested device meets a trigger condition for a battery evaluation task, control the to-be-tested device to perform a charging/discharging process corresponding to the battery evaluation task, obtain test data of the to-be-tested device in the charging/discharging process, and determine a battery evaluation result based on the test data; and
a transceiver unit, configured to send the battery evaluation result to a second device.

25. A battery evaluation apparatus, comprising:
a transceiver unit, configured to receive a battery evaluation result sent by a first device, wherein the battery evaluation result is determined by the first device based on test data of a to-be-tested device in a charging/discharging process corresponding to a battery evaluation task, and the charging/discharging process is performed by the to-be-tested device under control of the first device when the to-be-tested device meets a trigger condition for the battery evaluation task.

26. An electronic device, comprising a processor, wherein
when the processor invokes a computer program or instructions in a memory, the method according to any one of claims 1 to 16 is performed, or the method according to any one of claims 17 to 23 is performed.

27. A computer-readable storage medium, wherein the computer-readable storage medium stores a computer program or instructions, and when the computer program or the instructions are executed, the method according to any one of claims 1 to 16 or claims 17 to 23 is implemented.

28. A computer program product, comprising a computer program or instructions, wherein when the computer program or the instructions are executed, the method according to any one of claims 1 to 16 or claims 17 to 23 is implemented.

29. A system, comprising a first device and a second device, wherein the first device is configured to perform the method according to any one of claims 1 to 16, and the second device is configured to perform the method according to any one of claims 17 to 23.
